# EUROPÄISCHE PATENTSCHRIFT

(11) **EP 1 415 391 B1**
(45) Veröffentlichungstag und Bekanntmachung des Hinweises auf die Patenterteilung: **12.01.2005**
(21) Anmeldenummer: 02754423.8
(22) Anmeldetag: 24.07.2002
(51) Int. Cl.: H03C 3/40

(54) **SCHALTUNGSANORDNUNG ZUR REGELUNG EINES SIGNAL-GLEICHANTEILS UND MOBILFUNKSENDER**
CIRCUIT ARRANGEMENT FOR THE REGULATION OF A DIRECT COMPONENT OF A SIGNAL AND MOBILE RADIO TRANSMITTER
CIRCUIT DE REGLAGE D'UNE COMPOSANTE DE SIGNAL HOMOGENE ET EMETTEUR DE TELEPHONIE MOBILE

(30) Priorität: 27.07.2001 DE 10136741
(43) Veröffentlichungstag der Anmeldung: 06.05.2004
(73) Patentinhaber: Infineon Technologies AG, 81669 München (DE)
(72) Erfinder: ASAM, Michael, 85250 Wollomoos (DE)
(74) Vertreter: Epping Hermann & Fischer
(86) Internationale Anmeldenummer: PCT/DE2002/002712
(87) Internationale Veröffentlichungsnummer: WO 2003/012977

(56) Entgegenhaltungen:
- EP-A- 0 655 841
- EP-A- 0 693 823
- WO-A-99/26361
- US-A- 5 471 665
- US-A- 6 154 158

## Beschreibung

Die vorliegende Erfindung betrifft eine Schaltungsanordnung zur Regelung eines Signal-Gleichanteils und einen Mobilfunksender mit der Schaltungsanordnung.

Insbesondere bei Analogmultipliziererschaltungen, welche als Hochfrequenzmischer ausgelegt sind und betrieben werden, ist am Signaleingang, an dem das Nutzsignal zugeführt wird, ein Signal mit einem festen, vorbekannten Gleichanteil bereitzustellen. Je nachdem, ob der Eingang des Hochfrequenz-Mischers als Stromeingang oder als Spannungseingang ausgebildet ist, ist der Gleichanteil des Eingangssignals entweder als Gleichspannungsoffset oder als Gleichstrom-Offset bereitzustellen.

Bei Mobilfunkanwendungen sind üblicherweise zwei Funktionseinheiten vorgesehen, nämlich eine Basisband-Signalverarbeitung sowie eine üblicherweise in analoger Schaltungstechnik ausgebildete Hochfrequenz-Verarbeitung, welche meist in getrennten Integrierten Schaltkreisen (ICs, Integrated Circuits) angeordnet sind. In Senderichtung werden zu übertragende Signale in einem Basisband-Prozessor entsprechend der gewünschten Kanalcodierungs- und Modulationsverfahren verarbeitet und am Ausgang des Basisband-Blocks in einem Digital/Analog-Wandler in analoge, das heißt zeit- und wertkontinuierliche Signale umgewandelt. Dieses am Ausgang des Basisband-Chips bereitgestellte, analoge Signal ist üblicherweise als komplexwertiges Signal mit einer Inphase- und einer Quadratur-Komponente I, Q bereitgestellt, wobei I- und Q-Signalkomponente üblicherweise als symmetrische oder differentielle Signale geführt sind.

Im nachfolgenden Funktionsblock, der die Frequenzumsetzung auf einen hochfrequenten Träger durch eine Modulation, beispielsweise eine Quadratur-Modulation bewirkt, sind die eingangs beschriebenen Hochfrequenz-Mischer vorgesehen, welche die Frequenzumsetzung vom Basisband in eine hochfrequente Lage ermöglichen und ausgangsseitig beispielsweise an eine Sendeantenne angekoppelt sind. Der beschriebene Basisband-Verarbeitungsblock sowie der nachgeschaltete, analog ausgebildete, Funktionsblock sind üblicherweise auf je einem integrierten Halbleiterchip angeordnet. Da eingangsseitig am Hochfrequenz-Mischer ein Signal mit einem festen, vorbekannten Gleichanteil bereitgestellt sein muß, ist es erforderlich, daß der angeschlossene Basisband-Chip an seinem Ausgang einen passenden Gleichanteil bereitstellt.

Um einen Betrieb in einem gewünschten Arbeitspunkt des Frequenzmischers sicherzustellen, darf sich der eingangsseitige Gleichspannungs- beziehungsweise Gleichstromanteil nur in festgelegten Toleranzen bewegen. Die unterschiedlichen, verfügbaren Basisband-Chips haben jedoch am Ausgang unterschiedliche Gleichanteile, welche zudem noch Fertigungstoleranzen unterworfen sind.

In dem Dokument WO 99/26361 ist ein Modulationsystem angegeben. Am Eingang eines IQ-Modulators wird ein DC-Offset gemessen und zur Kompensation des DC-Offsets subtrahiert.

Aufgabe der vorliegenden Erfindung ist es, eine Schaltungsanordnung zur Regelung eines Signal-Gleichanteils anzugeben, welche an einen Eingang eines Hochfrequenz-Mischers anschließbar ist und den Anschluß an unterschiedliche Basisband-Signalverarbeitungsschaltungen ermöglicht, sowie einen Mobilfunksender mit der Schaltungsanordnung.

Erfindungsgemäß wird die Aufgabe bezüglich der Schaltungsanordnung gelöst durch eine Schaltungsanordnung zur Regelung eines Signal-Gleichanteils, aufweisend
- einen Modulator zur Frequenzumsetzung eines Eingangssignals, das an einem Eingang des Modulators zuführbar ist,
- einen Detektor zur Erfassung eines Gleichanteils des Eingangssignals, der an den Eingang des Modulators angeschlossen ist,
- einen Vergleicher, der mit einem ersten Eingang mit einem Ausgang des Detektors gekoppelt ist und dem an einem zweiten Eingang ein Soll-Signal zuführbar ist, und
- ein Mittel zur Beeinflussung des Gleichanteils des Eingangssignals, das dem Detektor vorgeschaltet ist, mit einem Steuereingang, der an einen Ausgang des Vergleichers angeschlossen ist.

Gemäß dem vorgeschlagenen Prinzip nach Patentanspruch 1 ist eine Schaltungsanordnung vorgesehen, welche eingangsseitig am Modulator den Gleichanteil des Eingangssignals auf einen vorgebbaren Soll-Wert einregelt, welcher zum Betrieb des Modulators geeignet ist und beispielsweise zu dessen Arbeitspunkteinstellung dienen kann. Hierdurch ergibt sich eine Unabhängigkeit von Ausgangssignal-Gleichanteilen eines vorangeschalteten Blocks, beispielsweise einer Basisband-Signalverarbeitungseinheit.

Liegt das Eingangssignal als symmetrisches Signal, das heißt als Gegentaktsignal vor, so ist als Gleichanteil des Signals der Gleichtakt-Anteil, englisch common-mode, verstanden.

Ist der Eingang des Modulators als Spannungseingang ausgebildet, so ist als Gleichanteil der Gleichspannungsanteil verstanden. Ist der Eingang des Modulators als Stromeingang ausgebildet, so ist als Gleichanteil der Gleichstrom-Anteil des Eingangssignals verstanden.

Das vorliegende Prinzip bietet den zusätzlichen Vorteil, neben der Kompensation fertigungsbedingter Toleranzen auch temperaturbedingte sowie alterungsbedingte Drifteffekte und einen dadurch variierenden Gleichanteil des Eingangssignals zu kompensieren.

In einer bevorzugten Ausführungsform der vorliegenden Erfindung ist ein Tiefpaßfilter vorgesehen, das den Ausgang des Detektors mit dem ersten Eingang des Vergleichers koppelt.

Besonders bei Führen des Eingangssignals auf einer Leitung, englisch single-ended, ist die Zwischenschaltung eines Tiefpaßfilters von Vorteil. Zudem verbessert das Tiefpaßfilter die Stabilität der Regelschleife.

In einer weiteren, bevorzugten Ausführungsform der vorliegenden Erfindung sind der Eingang des Modulators und der Detektor zur Verarbeitung eines symmetrischen Eingangssignals ausgelegt.

Die sogenannte differentielle Signalübertragung des Eingangssignals bietet neben der höheren Störfestigkeit die vereinfachte Ermittelbarkeit des Gleichanteils des Eingangssignals.

Bei Führen des Signals als symmetrisches Eingangssignal kann das Tiefpaßfilter entfallen.

In einer weiteren, bevorzugten Ausführungsform der vorliegenden Erfindung ist der Detektor zur Erfassung des Gleichspannungsanteils des Eingangssignals ausgelegt.

Ist der Modulatoreingang als Spannungseingang, das heißt hochohmig ausgebildet, so ist vorteilhafterweise zur Ermittlung des Offsets des Eingangssignals im Detektor eine Erfassung des Gleichspannungsanteils vorgesehen.

In einer weiteren, bevorzugten Ausführungsform der vorliegenden Erfindung umfaßt der Detektor zwei Widerstände, die mit einem Anschluß mit je einer Eingangsklemme des symmetrischen Eingangs des Modulators und mit einem weiteren Anschluß miteinander und mit dem Ausgang des Detektors verbunden sind.

Zur Ermittlung des Gleichspannungsanteils, das heißt des Gleichtaktsignals des symmetrischen Signals, können auch andere Realisierungen des Detektors vorgesehen sein. Die beschriebene Ausführung mit zwei Widerständen, welche bevorzugt den gleichen Widerstandswert haben, stellt eine besonders einfache Schaltungsrealisierung dar.

Bei Vorliegen des Eingangssignals als Spannungssignal ist das Mittel zur Beeinflussung des Gleichanteils des Eingangssignals, das dem Detektor vorgeschaltet ist, bevorzugt als Pegelschieber, englisch level shifter, ausgebildet, welches den vom Vergleicher bereitgestellten Gleichanteil zu dem Gleichanteil des Eingangssignals addiert beziehungsweise davon subtrahiert.

In einer weiteren, bevorzugten Ausführungsform der Erfindung ist der Detektor zur Erfassung des Gleichstromanteils des Eingangssignals ausgelegt.

Bei Anschluß der vorliegenden Regelschaltung an einen Stromeingang eines Modulators, beispielsweise eines Hochfrequenzmischers, ist der Detektor bevorzugt zur Erfassung des Gleichstromanteils des Eingangssignals ausgebildet.

In einer weiteren, bevorzugten Ausführungsform der vorliegenden Schaltungsanordnung umfaßt der Detektor zwei in Serie geschaltete, stromgesteuerte Spannungsquellen, mit je einem Steuereingang, der mit je einer Eingangsklemme des symmetrischen Eingangs des Modulators gekoppelt ist, wobei die Serienschaltung der beiden stromgesteuerten Spannungsquellen mit dem Ausgang des Detektors gekoppelt ist.

In einer besonders einfachen Schaltungsrealisierung können die beiden stromgesteuerten Spannungsquellen mit Widerständen aufgebaut sein.

Am Ausgang des Vergleichers sind bevorzugt gesteuerte Stromquellen angeschlossen, welche auf je eine Eingangsklemme des Modulators an dessen Eingang arbeiten und eingangsseitig jeweils an den stromgesteuerten Spannungsquellen angeschlossen sind. Damit regelt die beschriebene Schaltungsanordnung zwei gesteuerte Stromquellen am Eingang des Modulators, um damit den Gleichstromanteil gemäß dem vorgegebenen Referenzwert zu erhöhen oder zu erniedrigen.

Bei ausreichend klein gewählter Grenzfrequenz des Tiefpaßfilters, welches in einem Rückkopplungspfad der Regelschleife angeordnet ist, kann die beschriebene Schaltungsanordnung anstelle der symmetrischen Ausführung auch mit einer Signalführung auf nur einer Leitung, englisch single-ended, ausgeführt sein.

In einer weiteren, bevorzugten Ausführungsform der vorliegenden Erfindung umfaßt der Modulator einen Frequenzmischer, mit einem ersten Eingang, der mit dem Eingang des Modulators verbunden ist, mit einem zweiten Eingang, dem ein Signal mit einer Trägerfrequenz zuführbar ist, und mit einem Ausgang, an dem ein moduliertes Hochfrequenz-Signal ableitbar ist.

Ist der Modulator als Quadraturmodulator ausgebildet, so sind bevorzugt zwei Frequenzmischer vorgesehen, von denen einer von einer Inphase-Komponente und ein weiterer von einer Quadratur-Komponente eines Nutzsignals angesteuert wird. Dabei können die beschriebenen Schaltungsanordnungen zur Gleichanteil-Regelung bevorzugt bei beiden Nutzsignaleingängen der Frequenzmischer vorgesehen sein.

Das beschriebene Prinzip ist bevorzugt bei Sendeanordnungen, insbesondere im Mobilfunk, anwendbar. Das beschriebene Prinzip kann beispielsweise bei homodynen und heterodynen Sendearchitekturen eingesetzt werden. Sind mehrere Aufwärts-Frequenzmischer hintereinander geschaltet, so kann es vorteilhaft sein, an den Nutzsignal-Eingängen der mehreren, hintereinander geschalteten Frequenzumsetzer jeweils eine Schaltungsanordnung wie beschrieben vorzusehen.

Weitere Einzelheiten der Erfindung sind Gegenstand der Unteransprüche.

Die Erfindung wird nachfolgend an mehreren Ausführungsbeispielen anhand der Zeichnungen näher erläutert.

Es zeigen:
- Figur 1: ein erstes Ausführungsbeispiel der Erfindung anhand eines vereinfachten Blockschaltbildes angewendet auf einen Frequenzumsetzer mit einem Spannungseingang,
- Figur 2: ein weiteres Ausführungsbeispiel des vorliegenden Prinzips angewendet auf einen Frequenzumsetzer mit Stromeingang anhand eines vereinfachten Blockschaltbildes und
- Figur 3: das beschriebene Prinzip angewendet bei einem Quadraturmodulator in einem Mobilfunksender anhand eines vereinfachten Blockschaltbilds.

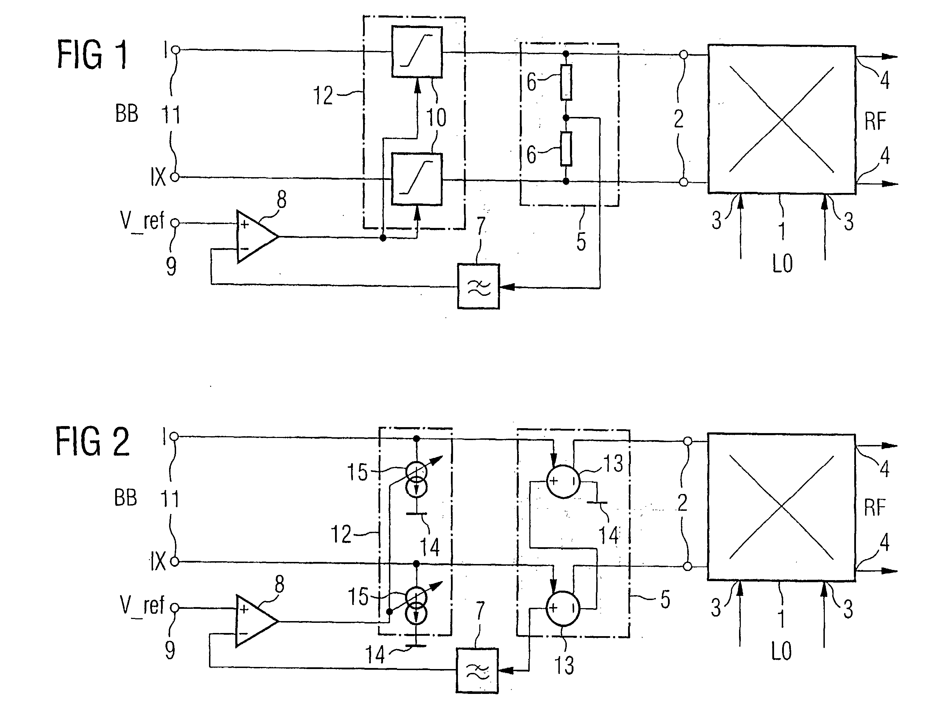

Figur 1 zeigt einen als Frequenzumsetzer ausgebildeten Hochfrequenzmischer 1, mit einem Eingang 2 zum Zuführen eines symmetrischen Basisbandsignals, einem Lokaloszillator-Eingang 3 zum Zuführen eines Signals mit einer Trägerfrequenz und mit einem Hochfrequenzausgang 4. Die Eingänge 2, 3 und der Ausgang 4 des Hochfrequenzmischers 1 sind jeweils symmetrisch zum Führen differentieller Signale ausgelegt. Der Hochfrequenzmischer 1 setzt ein an seinem Nutzsignal-Eingang 2 anliegendes Basisband-Signal in eine hochfrequente Lage um.

Am Eingang 2 des Hochfrequenzmischers 1 ist ein Detektor 5 angeschlossen, welcher zwei Widerstände 6, die einen gleichen Widerstandswert aufweisen, umfaßt. Die Widerstände 6 sind mit je einem Anschluß an je eine Klemme des symmetrischen Eingangs 2 angeschlossen und mit einem weiteren Anschluß miteinander verbunden unter Bildung eines Ausgangs des Detektors 5.

An diesem Ausgang des Detektors 5 ist zur Bildung einer negativen Rückkopplungsschleife einer Regelung über ein als RC-Glied ausgebildetes Tiefpaßfilter 7 der invertierende Eingang eines als Operationsverstärker ausgebildeten Vergleichers 8 angeschlossen. Der nicht-invertierende Eingang des Vergleichers 8 ist mit einem Anschluß 9 zum Zuführen eines Soll-Spannungspegels ausgebildet. Der Vergleicher 8 weist einen Ausgang auf, an dem je ein Steuereingang eines Pegelschiebers 10 angeschlossen ist. Die Pegelschieber 10 sind mit ihren Ausgängen unmittelbar an den Eingang des Detektors 5 und damit auch an den Eingang 2 des Mischers 1 angeschlossen. Den Eingängen der Pegelschieber 10 ist als symmetrisches Signal ein Basisband-Signal oder eine Signalkomponente eines komplexwertigen Basisband-Signals zuführbar. Die Eingänge der Pegelschieber 10 sind mit einem symmetrischen Basisband-Eingang 11 verbunden, der beispielsweise mit dem Ausgang einer Basisband-Signalverarbeitungseinheit verbindbar ist. Die Pegelschieber 10 bilden gemeinsam ein Mittel zur Beeinflussung des Gleichanteils des am Eingang 2 des Mischers 1 zuführbaren Eingangssignals und sind im vorliegenden Ausführungsbeispiel als Source-Folger ausgebildet.

Figur 1 zeigt lediglich die Regelschaltung für den Inphase-Signalpfad eines Mobilfunksenders, für den Quadratur-Signalpfad ist die gleiche Beschaltung eines Mischereingangs eines weiteren Mischers, wie in Figur 1, vorzusehen.

Der Mischer 1 benötigt zu seiner korrekten Funktionsweise eine feste, vorbekannte Gleichtaktspannung, das heißt ein festes DC-, Direct Current-Spannungsniveau an den Eingangsklemmen 2. Dieser Common-Mode-Gleichspannungsanteil wird mit den gleich großen Widerständen 6 am Ausgang des Vergleichers 5 bereitgestellt und als Ist-Wert auf den negativen Operationsverstärker-Eingang des Vergleichers 8 geführt. Bei der beschriebenen, symmetrischen Ausführung ist Tiefpaßfilter 7 nicht notwendigerweise vorhanden und kann auch durch einen Kurzschluß ersetzt werden. Das Tiefpaßfilter 7 unterdrückt insbesondere bei Single-Ended-Ausführung des Mischereingangs 2 das zu übertragende Nutzsignal. Tiefpaßfilter 7 sorgt zudem durch Anordnung im Rückkopplungspfad der Regelschleife für deren Stabilität.

Der Operationsverstärker 8 vergleicht den gefilterten Ist-Wert mit einem am Anschluß 9 bereitgestellten Soll-Wert des Gleichtakt-Signalanteils am Eingang 2 und steuert in Abhängigkeit von einer Abweichung zwischen Soll- und Ist-Signal zwei Pegelschieber 10 an, die das Gleichspannungspotential am Ausgang der Pegelschieber 10 in Abhängigkeit dieser Abweichung verändern. Hierdurch stellt sich nach Einschwingen der Regelschleife am Mischereingang 2 eine Gleichtaktspannung ein, die dem Sollwert, der am Anschluß 9 zugeführt wird, entspricht. Die Gate-Source-Spannung der als Source-Folger ausgebildeten Pegelschieber 10 hängt dabei vom Strom im MOS-Feldeffekttransistor 10 ab.

Wird in einer Abwandlung der Regelung gemäß Figur 1 anstelle der symmetrischen Signalübertragung eine unsymmetrische Signalübertragung auf einer Leitung gewählt, so ist die Grenzfrequenz des Tiefpaßfilters 7 verhältnismäßig niedrig einzustellen, um Nutzsignale auszufiltern und nicht in die Regelung mit einfließen zu lassen. Eine beispielhafte Anwendung ist bei Mobilfunksendern gemäß UMTS, Universal Mobile Telecommunication System, gegeben, da die Basisband-Signale dort verhältnismäßig hochfrequent sind.

Die Schaltung gemäß Figur 1 ermöglicht einen Betrieb des Mischers 1 in seinem gewünschten Arbeitspunkt und erlaubt zugleich, der gezeigten Schaltung einen Integrierten Schaltkreis mit nahezu beliebigem Ausgangssignal-Gleichanteil vorzuschalten. Zudem werden alterungs- und temperaturbedingte Drifteffekte ausgeregelt, so daß ein Wegdriften des Arbeitspunktes des Mischers 1 vermieden wird.

Figur 2 beschreibt das erfindungsgemäße Prinzip angewendet auf einen Hochfrequenzmischer 1, bei dem der Nutzsignaleingang 2 als Stromeingang ausgebildet ist. Hierdurch sind lediglich Detektor 5 und das Mittel zur Beeinflussung des Gleichtakt-Signalanteils 12 daran angepaßt anders ausgeführt als bei der Schaltung gemäß Figur 1, im übrigen entspricht das Blockschaltbild gemäß Figur 2 in Aufbau und Funktion dem von Figur 1 und wird an dieser Stelle nicht noch einmal wiederholt.

Gemäß Figur 2 umfaßt der Detektor 5 zwei stromgesteuerte Spannungsquellen 13, welche je einen Steuereingang und zwei Lastanschlüsse aufweisen. Lastseitig sind die gesteuerten Spannungsquellen 13 in einer Serienschaltung miteinander verbunden, welche zwischen einen Bezugspotentialanschluß 14 und einen Eingang des Tiefpaßfilters 7 geschaltet ist. Die Steuereingänge der stromgesteuerten Spannungsquellen 13 sind jeweils mit dem symmetrischen Eingang 2 des Mischers 1 über je eine Eingangsklemme sowie mit dem symmetrischen Ausgang des Mittels zur Beeinflussung des Gleichtaktsignals 12 verbunden.

Ausgangsseitig an den Vergleicher 8 ist je eine gesteuerte Stromquelle 15 mit ihrem Steuereingang angeschlossen, welche lastseitig über die Steuereingänge der gesteuerten Quellen 13 mit dem symmetrischen Eingang 2 des Mischers 1 gekoppelt sind. Die gesteuerten Stromquellen 15, sind weiterhin jeweils mit Bezugspotentialanschluß 14 verbunden.

Gemäß Figur 2 hat der Mischer 1 einen differentiellen Stromeingang zur Zuführung eines Basisband-Eingangssignals. Der am Stromeingang 11 der Schaltung gemäß Figur 2 anschließbare Basisband-Chip liefert das Basisband-Nutzsignal in Form eines Stromsignals, mit einem festen Common-Mode(CM)-Gleichstrom(DC)-anteil. Um diesen CM-DC-Strom auf einen für den Mischer 1, insbesondere im Hinblick auf dessen Arbeitspunkt, geeigneten Wert einzustellen, wird er mit Hilfe zweier stromgesteuerter Spannungsquellen 13, die in einer besonders einfachen Realisierung als Widerstände ausgebildet sein können, in eine Spannung umgewandelt. Diese Spannung wird dem Vergleicher 8 über ein Filter 7 zugeführt, wie bei Figur 1 beschrieben. Der Operationsverstärker 8 vergleicht dieses Ist-Signal mit einem Soll-Wert, wobei in Abhängigkeit einer Abweichung zwischen Ist- und Soll-Signal zwei gesteuerte Stromquellen 15, die lastseitig mit dem Eingang 2 des Mischers 1 verbunden sind, gesteuert werden. Die Stromquellen 15, welche ebenso wie die gesteuerten Spannungsquellen 13 bevorzugt eine gute Paarung aufweisen, erhöhen beziehungsweise erniedrigen in Abhängigkeit dieser Abweichung den Gleichstromanteil des Eingangssignals.

In einer alternativen Ausführungsform der Schaltung gemäß Figur 2 kann diese auch in unsymmetrischer Schaltungstechnik, das heißt ausgebildet zur Führung von Single-Ended-Signalen, ausgeführt sein. Hierbei ist eine ausreichend kleine Grenzfrequenz des Tiefpaßfilters 7 vorzusehen.

Die Schaltungen gemäß Figuren 1 und 2 haben den Vorteil, daß mit der beschriebenen Gleichanteil-Regelung ein Mischer 1 in einem gewünschten Arbeitspunkt betrieben werden kann und zugleich eine Hochfrequenz-Baugruppe beispielsweise eines Mobilfunk-Modulators an eine Basisband-Signalverarbeitungsschaltung mit nahezu beliebigen Gleichtaktanteil angeschlossen werden kann.

Da die beschriebene Regelung im Normalbetrieb, das heißt im Sendebetrieb immer in Betrieb, das heißt aktiviert sein kann, können zusätzlich fertigungsbedingte, temperaturbedingte sowie alterungsbedingte Drifteffekte und Toleranzen ausgeglichen werden.

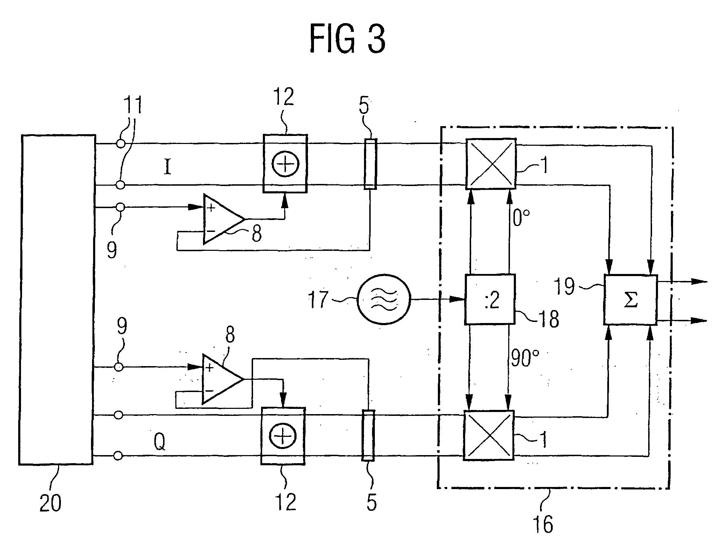

Figur 3 zeigt anhand eines vereinfachten Blockschaltbildes die Regelung gemäß Figur 1 und 2 angewendet auf einen Quadraturmodulator 16 einer Mobilfunk-Sendeanordnung. Die Mobilfunk-Sendeanordnung umfaßt dabei einen Basisband-Signalverarbeitungsblock 20.

Der Quadraturmodulator 16 weist zwei Hochfrequenzmischer 1 auf, von einen einer an seinem Signaleingang mit einem Inphase-Signalpfad I und der andere an seinem Signaleingang mit einem Quadratur-Signalpfad Q eines komplexwertigen Nutzsignals verbunden ist. Weiterhin ist den Frequenzmischern 1 an je einem weiteren Eingang ein Lokaloszillatorsignal, welches von einem Oszillator 17 bereitgestellt und in einem Frequenzteiler 18 frequenzmäßig heruntergeteilt wird, zum einen unverändert und zum anderen mit einer Phasenverschiebung von 90° zuführbar. Die Signalausgänge der Frequenzmischer 1 sind jeweils mit einem Summierglied 19 verbunden, welches an seinem Ausgang ein Hochfrequenzsignal bereitstellt, das beispielsweise in eine Sendeantenne einkoppelbar ist.

Eingangsseitig an den Hochfrequenzmischern 1 ist sowohl im Inphase-Signalpfad I, als auch im Quadratur-Signalpfad Q jeweils eine Regelung des Gleichtaktpegels gemäß dem vorliegenden Prinzip, beispielsweise gemäß Figur 1 oder 2, vorgesehen, welche jeweils einen Detektor 5 mit vorgeschaltetem Mittel zur Beeinflussung des Gleichtaktpegels 12 umfaßt und eingangsseitig am Hochfrequenzmischer angeschlossen ist. Es ist weiterhin jeweils ein Vergleicher 8 in einem Rückkoplungspfad vorgesehen, der ein vom Detektor 5 bereitgestelltes Ist-Signal mit einem an einem Anschluß 9 zuführbaren Soll-Gleichtaktwert vergleicht und in Abhängigkeit einer Abweichung zwischen Soll- und Ist-Wert jeweils das Mittel zur Beeinflussung des Gleichtaktpegels 12 ansteuert.

Eingangsseitig an den in I- und Q- Signalpfad vorgesehenen Mitteln zur Beeinflussung des Gleichtaktpegels 12 ist der Basisband-Signalverarbeitungblock 20 angeschlossen.

Im Rückkopplungspfad zwischen Detektor 5 und Vergleicher 8 kann zusätzlich ein Tiefpaßfilter vorgesehen sein.

Je nachdem, ob die Hochfrequenzmischer 1 Spannungs- oder Stromeingänge aufweisen, kann zur Gleichtaktregelung eine Schaltung gemäß Figur 1 oder Figur 2 vorgesehen sein.

Je nach gewünschtem, vorgegebenen Arbeitspunkt der Mischer 1 ist am Anschluß 9 ein entsprechender Gleichtakt-Sollwert zuzuführen.

Der Quadraturmodulator 16 mit der beschriebenen Gleichtaktpegelregelung am Eingang ist vollständig in symmetrischer Schaltungstechnik zur Führung differentieller Signale ausgebildet.

Die Anschlüsse 9 der beiden Vergleicher 8 können miteinander verbunden sein.

Der Quadratur-Modulator 16 moduliert die I- und Q-Signale auf ein hochfrequentes Trägersignal. Um einen definierten Arbeitspunkt der Mischer 1 sicherzustellen, ist die beschriebene eingangsseitige Regelung geeignet. Hierdurch ist eine Unabhängigkeit von Gleichanteilen eines Nutzsignals, welches ausgangsseitig an einem Basisband-Chip bereitgestellt wird, erzielt. Hierdurch kann der beschriebene Modulator gemäß Figur 3 als Hochfrequenz-Frontend, welches in analoger Schaltungstechnik aufgebaut ist, mit nahezu beliebigen Basisband-Chips zur Bildung eines Mobilfunksenders kombiniert werden.

### Bezugszeichenliste

- 1: Mischer
- 2: Eingang
- 3: LO-Eingang
- 4: Ausgang
- 5: Common-Mode Detektor
- 6: Widerstand
- 7: Tiefpaß
- 8: Vergleicher
- 9: Anschluß
- 10: Pegelschieber
- 11: Eingangsanschluß
- 12: Mittel zur Beeinflussung des Gleichtaktpegels
- 13: gesteuerte Spannungsquelle
- 14: Bezugspotentialanschluß
- 15: gesteuerte Stromquelle
- 16: Quadraturmodulator
- 17: Oszillator
- 18: Teiler
- 19: Summierer
- 20: Basisband-Chip
- I: Inphase-Signalzweig
- Q: Quadratur-Signalzweig

## Patentansprüche

1. Schaltungsanordnung zur Regelung eines Signal-Gleichanteils, aufweisend
- einen Modulator (16) zur Frequenzumsetzung eines Eingangssignals, das an einem Eingang (2) des Modulators (16) zuführbar ist,
- einen Detektor (5) zur Erfassung eines Gleichanteils des Eingangssignals, der an den Eingang (2) des Modulators (16) angeschlossen ist,
- einen Vergleicher (8) mit einem ersten Eingang, der mit einem Ausgang des Detektors (5) gekoppelt ist, und mit einem zweiten Eingang, an dem ein Soll-Signal zuführbar ist, und
- ein Mittel zur Beeinflussung des Gleichanteils (12) des Eingangssignals, das dem Detektor (5) vorgeschaltet ist, mit einem Steuereingang, der an einen Ausgang des Vergleichers (8) angeschlossen ist.

2. Schaltungsanordnung nach Anspruch 1,
**dadurch gekennzeichnet, daß**
ein Tiefpaß-Filter (7) vorgesehen ist, das den Ausgang des Detektors (5) mit dem ersten Eingang des Vergleichers (8) koppelt.

3. Schaltungsanordnung nach Anspruch 1 oder 2,
**dadurch gekennzeichnet, daß**
der Eingang (2) des Modulators (16) und der Detektor (5) zur Verarbeitung eines symmetrischen Eingangssignals ausgelegt sind.

4. Schaltungsanordnung nach einem der Ansprüche 1 bis 3,
**dadurch gekennzeichnet, daß**
der Detektor (5) zur Erfassung des Gleichspannungsanteils des Eingangssignals ausgelegt ist.

5. Schaltungsanordnung nach Anspruch 3 und 4,
**dadurch gekennzeichnet, daß**
der Detektor (5) zwei Widerstände (6) umfaßt, die mit einem Anschluß mit je einer Eingangsklemme des symmetrischen Eingangs (2) des Modulators (16) und mit einem weiteren Anschluß miteinander und mit dem Ausgang des Detektors (5) verbunden sind.

6. Schaltungsanordnung nach einem der Ansprüche 1 bis 3,
**dadurch gekennzeichnet, daß**
der Detektor (5) ausgelegt ist zur Erfassung des Gleichstromanteils des Eingangssignals.

7. Schaltungsanordnung nach Anspruch 3 und 6,
**dadurch gekennzeichnet, daß**
der Detektor (5) zwei in Serie geschaltete, stromgesteuerte Spannungsquellen (13) umfaßt, mit je einem Steuereingang, der mit je einer Eingangsklemme des symmetrischen Eingangs (2) des Modulators (16) gekoppelt ist, wobei die Serienschaltung der beiden stromgesteuerten Spannungsquellen (13) mit dem Ausgang des Detektors (5) gekoppelt ist.

8. Schaltungsanordnung nach einem der Ansprüche 1 bis 7,
**dadurch gekennzeichnet, daß**
der Modulator (16) zumindest einen Frequenzmischer (1) umfaßt, mit einem ersten Eingang (2), der mit dem Eingang des Modulators verbunden ist, mit einem zweiten Eingang (3), dem ein Signal mit einer Trägerfrequenz zuführbar ist und mit einem Ausgang (4), an dem ein moduliertes Hochfrequenz-Signal ableitbar ist.

9. Mobilfunksender mit einer Schaltungsanordnung nach einem der Ansprüche 1 bis 8, aufweisend
eine Basisband-Signalverarbeitungsenheit (20) mit einem Ausgang zur Bereitstellung eines Nutzsignals, der mit einem Nutzsignal-Eingang (11) des Mittels zur Beeinflussung des Gleichanteils (12) verbunden ist.

## Claims

1. Circuit arrangement for regulating a signal DC component, having
- a modulator (16) for the frequency conversion of an input signal which can be fed in at an input (2) of the modulator (16),
- a detector (5) for the detection of a DC component of the input signal, which is connected to the input (2) of the modulator (16),
- a comparator (8) having a first input, which is coupled to an output of the detector (5), and having a second input, at which a desired signal can be fed in, and
- a means for influencing the DC component (12) of the input signal, which is connected upstream of the detector (5), having a control input connected to an output of the comparator (8).

2. Circuit arrangement according to Claim 1,
**characterized in that**
a low-pass filter (7) is provided, which couples the output of the detector (5) to the first input of the comparator (8).

3. Circuit arrangement according to Claim 1 or 2,
**characterized in that**
the input (2) of the modulator (16), and the detector (5) are designed for processing a symmetrical input signal.

4. Circuit arrangement according to one of Claims 1 to 3,
**characterized in that**
the detector (5) is designed for detecting the DC voltage component of the input signal.

5. Circuit arrangement according to Claims 3 and 4,
**characterized in that**
the detector (5) comprises two resistors (6), which are connected by one connection to a respective input terminal of the symmetrical input (2) of the modulator (16) and are connected by a further connection to one another and to the output of the detector (5).

6. Circuit arrangement according to one of Claims 1 to 3,
**characterized in that**
the detector (5) is designed for detecting the direct-current component of the input signal.

7. Circuit arrangement according to Claims 3 and 6,
**characterized in that**
the detector (5) comprises two series-connected, current-controlled voltage sources (13), having a respective control input coupled to a respective input terminal of the symmetrical input (2) of the modulator (16), the series connection of the two current-controlled voltage sources (13) being coupled to the output of the detector (5).

8. Circuit arrangement according to one of Claims 1 to 7,
**characterized in that**
the modulator (16) comprises at least one frequency mixer (1), having a first input (2), which is connected to the input of the modulator, having a second input (3), to which a signal having a carrier frequency can be fed, and having an output (4), at which a modulated radiofrequency signal can be derived.

9. Mobile radio transmitter having a circuit arrangement according to one of Claims 1 to 8, having a baseband signal processing unit (20) having an output for providing a useful signal, which is connected to a useful signal input (11) of the means for influencing the DC component (12).

## Revendications

1. Circuit de régulation d'une composante continue de signal, comportant :
- un modulateur (16) pour la conversion de fréquence d'un signal d'entrée qui peut être envoyé à une entrée (2) du modulateur (16),
- un détecteur (5) pour la détection d'une composante continue du signal d'entrée, qui est raccordé à l'entrée (2) du modulateur (16),
- un comparateur (8) avec une première entrée qui est couplée à une sortie du détecteur (5) et avec une deuxième entrée à laquelle un signal de consigne peut être envoyé, et
- un moyen pour influencer la composante continue (12) du signal d'entrée, qui est monté du côté amont du détecteur (5), avec une entrée de commande qui est raccordée à une sortie du comparateur (8).

2. Circuit selon la revendication 1,
**caractérisé par le fait qu'**il est prévu un filtre passe-bas (7) qui couple la sortie du détecteur (5) avec la première entrée du comparateur (8).

3. Circuit selon la revendication 1 ou 2,
**caractérisé par le fait que** l'entrée (2) du modulateur (16) et le détecteur (5) sont conçus pour le traitement d'un signal d'entrée symétrique.

4. Circuit selon l'une des revendications 1 à 3,
**caractérisé par le fait que** le détecteur (5) est conçu pour la détection de la composante en tension continue du signal d'entrée.

5. Circuit selon la revendication 3 et la revendication 4,
**caractérisé par le fait que** le détecteur (5) comprend deux résistances (6) qui sont reliées par une borne chacune à une borne d'entrée de l'entrée symétrique (2) du modulateur (16) et par une autre borne l'une à l'autre et à la sortie du détecteur (5).

6. Circuit selon l'une des revendications 1 à 3,
**caractérisé par le fait que** le détecteur (5) est conçu pour la détection de la composante en courant continu du signal d'entrée.

7. Circuit selon la revendication 3 et la revendication 6,
**caractérisé par le fait que** le détecteur (5) comprend deux sources de tension (13) branchées en série et commandées par courant, avec à chaque fois une entrée de commande qui est couplée à chaque fois à une borne d'entrée de l'entrée symétrique (2) du modulateur (16), le montage en série des deux sources de tension (13) commandées par courant étant couplé à la sortie du détecteur (5).

8. Circuit selon l'une des revendications 1 à 7,
**caractérisé par le fait que** le modulateur (16) comprend au moins un mélangeur de fréquence (1), avec une première entrée (2) qui est reliée à l'entrée du modulateur, avec une deuxième entrée (3) auquel un signal avec une fréquence porteuse peut être envoyé et avec une sortie (4) auquel un signal à haute fréquence et modulé peut être prélevé.

9. Emetteur de radiocommunication mobile avec un circuit selon l'une des revendications 1 à 8, comportant une unité de traitement de signal en bande de base (20) avec une sortie qui est destinée à la fourniture d'un signal utile et qui est reliée à une entrée de signal utile (11) du moyen prévu pour influencer la composante continue (12).
